# DEMANDE DE BREVET EUROPEEN

(11) **EP 1 959 521 A1**
(43) Date de publication de la demande: **20.08.2008**
(21) Numéro de dépôt: 07290176.2
(22) Date de dépôt: 13.02.2007
(51) Int. Cl.: H01R 13/24, G01R 1/073

(54) **Connecteur électrique intercalaire du type à aiguilles**

(71) Demandeur: Sabatier, André, 94190 Villeneuve-Saint-Georges (FR); Dupont, Georges, 92130 Issy-Les-Moulineaux (FR)
(72) Inventeur: Sabatier, André, 94190 Villeneuve-Saint-Georges (FR); Dupont, Georges, 92130 Issy-Les-Moulineaux (FR)
(74) Mandataire: Flavenot, Bernard

(57) **Abrégé**

La présente invention concerne les connecteurs électriques intercalaires à aiguilles 1 pour relier un connecteur de distribution à un circuit électronique à tester.

Le connecteur intercalaire se caractérise par le fait qu'il comporte des aiguilles 1, une plaque 2 comportant des percées 30 dont la section est égale à celle des aiguilles, une plaque 12 comportant des percées 31 dont la section est égale à celle des aiguilles, un empilage 50 situé entre les plaques 2 et 12 constitué d'une plaque 4 comportant des percées oblongues 5 dont la largeur et la longueur sont respectivement égale et supérieure à la section des aiguilles et d'une plaque 9 comportant des percées 32 dont la section est égale à la section des aiguilles, et des moyens 40 pour monter les quatre plaques de façon que les axes des percées 30, 31, 32 soient tous sur un même axe 3, la plaque 4 étant positionnée par rapport aux trois autres de façon que l'axe 3 soit tangent à la paroi de la percée oblongue 5 correspondant à sa largeur.

Application aux connecteurs pour tester des circuits électroniques comme des puces électroniques ou analogues.

## Description

La présente invention concerne les connecteurs électriques intercalaires du type "à aiguilles" pour relier les bornes d'un connecteur de distribution ou analogue avec les bornes d'un circuit électronique à tester du genre puce électronique ou analogue.

On sait que les composants électroniques atteignent des dimensions de plus en plus petites et que leurs contacts électriques peuvent avoir des dimensions inférieures à cinquante microns avec des entraxes entre deux contacts contigus de l'ordre de soixante cinq microns. Actuellement, pour un composant électronique du type «puce électronique », le nombre de ces contacts répartis sur une surface de plus en plus réduite peut dépasser plusieurs centaines.

Pour pouvoir relier électriquement les entrées-sorties de ces composants électroniques avec celles des appareils utilisés pour les tester, il a donc été nécessaire de réaliser des connecteurs électriques à contacts multiples spécifiques.

Un tel type de connecteur électrique à contacts multiples est par exemple décrit dans le FR-A-2 748 813 plus particulièrement illustré sur la figure 1 annexée à la partie descriptive de ce document.

Ce connecteur électrique à contacts multiples comporte un corps délimitant une cavité dans laquelle sont logées trois plaques respectivement supérieure, intermédiaire et inférieure sensiblement parallèles et réalisées dans un matériau électriquement isolant.

Ces plaques comportent une multiplicité de trous traversants disposés pour être aptes à être traversés par des aiguilles de contact réalisées en un matériau électriquement conducteur, d'une longueur supérieure à la distance séparant les plaques supérieure et inférieure de sorte qu'elles émergent de part et d'autre de ces deux plaques. L'une des extrémités des aiguilles, par exemple celle émergeant de la plaque supérieure, est reliée de façon filaire aux entrées-sorties des appareils de test, tandis que le corps du connecteur est déplacé de façon que les extrémités des aiguilles émergeant de la plaque inférieure viennent au contact mécanique des entrées-sorties du composant électronique à tester.

Il est cependant bien évident qu'il est impossible de déterminer avec une absolue précision la longueur de ces aiguilles pour que leurs extrémités émergeant de la plaque inférieure viennent toutes simultanément au contact des entrées-sorties du composant électronique à tester.

Pour cela, le connecteur comporte en outre des moyens pour déplacer la plaque intermédiaire dans au moins une direction afin de réaliser un pré flambage unidirectionnel des aiguilles. De cette façon, en exerçant une contrainte sur le corps du connecteur, il est possible d'amener toutes les extrémités des aiguilles émergeant de la plaque inférieure au contact des entrées-sorties du composant électronique à tester, les différences de niveau de ces entrées-sorties et les différences de longueur des aiguilles étant compensées par une déformation plus ou moins importante des aiguilles, cette déformation étant favorisée par leur pré flambage produit par le déplacement de la plaque intermédiaire comme plus amplement décrit dans ce document antérieur, notamment en regard de la figure 5 annexée à la partie descriptive de ce document.

Le connecteur électrique décrit dans ce document donne satisfaction, mais sa structure ne permet pas encore de répondre aisément à la miniaturisation de plus en plus poussée des composants électroniques et à l'augmentation de plus en plus importante du nombre de contacts électriques à réaliser dans des espaces de plus en plus réduits.

En outre, le déplacement en translation des plaques les unes par rapport aux autres est d'une réalisation technique relativement délicate du fait des dimensions intrinsèques aussi bien des bornes du circuit à tester que de celles des entre axes les séparant.

Il est connu un autre connecteur électrique de ce type, celui qui est décrit dans le US-A-4 622 514. Cependant, ce connecteur présente sensiblement les mêmes inconvénients que ceux mentionnés ci-dessus pour le connecteur selon le FR-A-2 748 813.

Aussi, la présente invention a-t-elle pour but de réaliser un connecteur électrique intercalaire du type "à aiguilles" pour relier les bornes d'un connecteur de distribution ou analogue avec les bornes d'un circuit électronique à tester du genre puce électronique ou analogue, qui pallie au moins en grande partie les inconvénients mentionnés ci-dessus des connecteurs similaires de l'art antérieur et notamment celui décrit ci-dessus.

Plus précisément, la présente invention a pour objet un connecteur électrique intercalaire du type "à aiguilles" pour relier les bornes d'un connecteur de distribution avec les bornes d'un circuit électronique à tester, selon la revendication 1 annexée.

D'autres caractéristiques et avantages de l'invention apparaîtront au cours de la description suivante donnée en regard des dessins annexés à titre illustratif mais nullement limitatif, dans lesquels :
La Figure 1 représente un schéma bloc du connecteur électrique intercalaire du type "à aiguilles" selon l'invention **Ca** reliant les bornes d'un connecteur de distribution **Cd** ou analogue avec les bornes d'un circuit électronique à tester **Ce** du genre puce électronique ou analogue, et
La figure 2 représente une vue en coupe longitudinale schématique d'un mode de réalisation du connecteur électrique intercalaire selon l'invention.

Il est précisé que les deux figures représentent un mode de réalisation de l'objet selon l'invention, mais qu'il peut exister d'autres modes de réalisation qui répondent à la définition de cette invention.

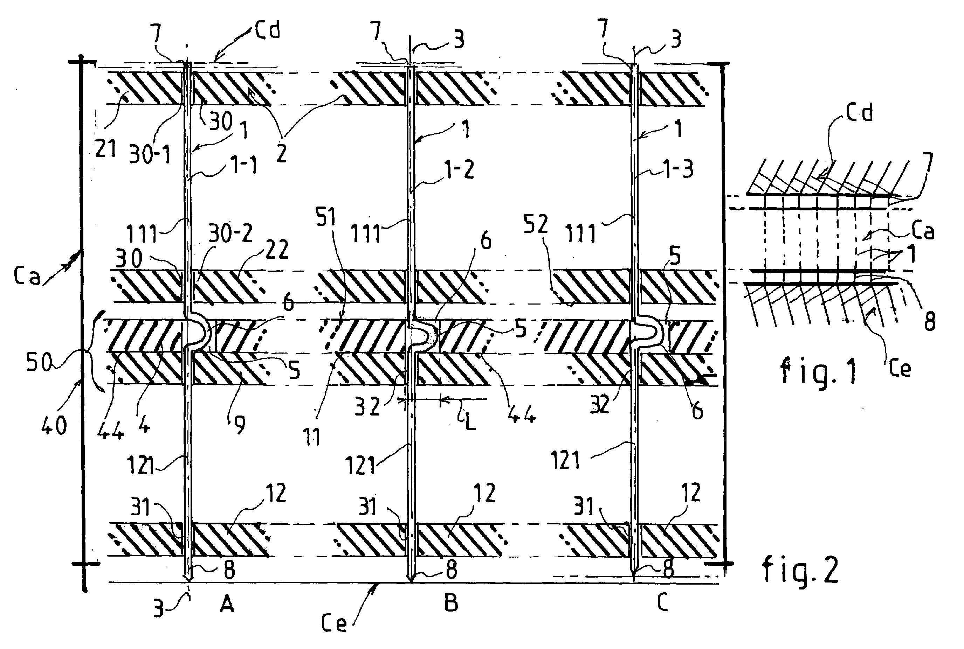

La présente invention concerne les connecteurs électriques intercalaires du type "à aiguilles" **Ca** pour relier les bornes d'un connecteur de distribution **Cd** ou analogue avec les bornes d'un circuit électronique à tester **Ce** du genre puce électronique ou analogue, comme représenté sur la figure 1.

Par référence aux figures 1 et 2, le connecteur intercalaire selon l'invention comporte essentiellement une pluralité d'aiguilles 1 disposées les unes par rapport aux autres suivant une répartition donnée fonction de la position des bornes du circuit à tester, chaque aiguille définissant un axe général 3. Sur la figure 2, seulement trois aiguilles 1-1, 1-2 et 1-3 respectivement dans trois situations différentes sont respectivement représentées dans les parties A, B et C de cette figure 2, mais il est bien évident qu'un tel connecteur intercalaire en comporte beaucoup plus.

Chaque aiguille est définie structurellement de façon que, sur une partie de sa longueur entre ses deux extrémités 7, 8, elle puisse subir des déplacements latéraux notables par déformation élastique. Pour ce faire, elle est avantageusement conformée, par exemple sensiblement dans sa partie médiane, en une boucle de dilatation 6 en forme préférentielle de "U" ou analogue, et elle est réalisée en un matériau choisi de façon que cette déformation latérale en boucle 6 forme ressort et reste dans le cadre d'une déformation élastique sans devenir une déformation plastique qui, elle, n'est pas élastique. Cette déformation latérale élastique a pour fonction d'absorber de façon réversible toutes variations de distance entre les deux extrémités 7, 8 de l'aiguille. Le choix de ce matériau est bien entendu du domaine de l'homme du métier qui saura le déterminer, ne serait-ce que par expérimentation, pour réaliser de telles aiguilles avec l'élasticité désirée pour obtenir le résultat explicité ci-après.

Le connecteur intercalaire comporte une première plaque de guidage 2 qui comporte des premières percées 30 parallèles entre elles et en nombre au moins égal au nombre d'aiguilles 1, la section de ces premières percées étant sensiblement égale à la section transversale des aiguilles de façon que ces dernières puissent y coulisser en translation sans subir de déplacements latéraux notables, mais cependant avec un minimum de frottements. La partie 111 d'une aiguille 1 comprise entre son extrémité 7 apte à venir au contact d'une borne du connecteur de **Cd** et la boucle 6 est montée coulissante dans une telle première percée 30.

La première plaque de guidage 2 peut être constituée d'une seule plaque ou de plusieurs plaques auxiliaires de guidage. Dans le mode de réalisation illustré sur la figure 2, elle est constituée de deux plaques auxiliaires de guidage parallèles 21, 22 situées à une certaine distance l'une de l'autre. Dans ce cas, chaque première percée 30 est constituée de deux premières percées auxiliaires 30-1, 30-2 réalisées sur le même axe général 3 respectivement dans chaque première plaque auxiliaire 21, 22.

Le connecteur intercalaire comporte aussi une deuxième plaque de guidage 12 comportant des deuxièmes percées 31 parallèles entre elles en nombre au moins égal au nombre d'aiguilles 1 et d'une section au moins égale à la section transversale des aiguilles de façon que ces dernières puissent y coulisser en translation de la même façon que dans les premières percées 30.

Le connecteur intercalaire comporte en outre un empilage 50 de deux troisième 4 et quatrième 9 plaques de guidage, situé entre les première 2 et deuxième 12 plaques de guidage.

La troisième plaque de guidage 4 comporte des troisièmes percées oblongues 5 en nombre au moins égal au nombre d'aiguilles 1. La largeur et la longueur L de la section de ces troisièmes percées oblongues dans un plan perpendiculaire à l'axe général 3 défini ci-avant étant respectivement sensiblement égale et supérieure à la section transversale des aiguilles, de façon que ces dernières puissent y coulisser tout en étant aptes à subir des déplacements latéraux notables par déformation élastique.

Plus précisément, la longueur L des troisièmes percées oblongues 5 définie ci-dessus est au moins égale à la hauteur maximale que peuvent prendre les boucles 6 décrites ci-avant prise perpendiculairement à l'axe général 3 quand la distance entre les deux extrémités 7, 8 des aiguilles est minimale. Cette troisième plaque de guidage 4 qui permet d'orienter la boucle 6 est montée en coopération avec la première plaque de guidage 2 de façon que l'axe général 3 de l'aiguille soit confondu avec l'axe des percées 30 et le bord de la percée oblongue et que donc la boucle 6 soit contenue au moins en partie dans cette percée oblongue 5.

Quant à la quatrième plaque de guidage 9, elle comporte des quatrièmes percées 32 parallèles entre elles et en nombre au moins égal au nombre d'aiguilles, la section de ces quatrièmes percées 32 étant sensiblement égale à la section transversale des aiguilles de façon que ces dernières puissent y coulisser en translation sans subir des déplacements latéraux notables, comme dans les premières et deuxièmes percées 30, 31.

Le connecteur intercalaire comporte enfin des moyens 40 pour monter et maintenir les première, deuxième, troisième et quatrième plaques de guidage de façon que les axes des percées correspondantes 30, 31, 32 respectivement réalisées dans les première, deuxième et quatrième plaques 2, 12, 9 et aptes à recevoir une même aiguille 1 soient tous sur le même axe général 3, et que cet axe général 3 soit sensiblement tangent à la partie de paroi de la troisième percée oblongue 5 correspondant à sa largeur de façon que la boucle 6 soit contenue au moins en partie dans la percée oblongue 5.

Ces derniers moyens 40 de montage et de maintien des quatre plaques 2 (ou 21-22), 4, 9, 12 sont avantageusement essentiellement constitués d'un boîtier enfermant latéralement ces plaques, les deux faces opposées étant ouvertes pour permettre aux extrémité 7, 8 des aiguilles d'émerger de boîtier pour venir au contact des bornes respectivement du connecteur de distribution **Cd** et du circuit électronique **Ce** à tester, comme une puce électronique ou analogue.

L'empilage 50 décrit ci-dessus est positionné par rapport à la première plaque de guidage 2 de façon que leurs faces respectives en regard 51, 52 soient situées à une certaine distance l'une de l'autre non nulle pour permettre à la boucle 6 de déborder de la percée oblongue 5 quand elle vient en butée contre la face 11 de la quatrième plaque de guidage 9 comme visible sur la figure 2 et comme explicité ci-après.

Comme visible sur la figure 2, les première et deuxième plaques de guidage 2, 12 sont situées de part et d'autre de l'empilage 50 de façon que la partie 121 de chaque aiguille comprise entre sa boucle 6 et son extrémité 8 apte à venir au contact d'une borne du circuit électronique à tester **Ce** soit montée coulissante dans une deuxième percée 31 et une quatrième percée 32.

Si on suppose que le connecteur intercalaire selon l'invention est utilisé de façon que les aiguilles 1 soient verticales, ce qui est généralement le cas, et que leurs extrémités 7 aptes à venir au contact de bornes du connecteur de distribution **Cd** soient en position haute, la quatrième plaque de guidage 9 est interposée entre la deuxième plaque de guidage 12 et la troisième plaque de guidage 4, et avantageusement de façon que sa face supérieure 11 soit au contact de la face inférieure 44 de la troisième plaque de guidage , sinon très proche, de façon que la boucle 6 demeure constamment au moins partiellement dans la percée oblongue 5.

De cette façon, les deux extrémités 7, 8 des aiguilles sont libres et le connecteur intercalaire peut être amené dans sa position verticale de façon que les extrémités inférieures 8 des aiguilles viennent au contact des bornes du circuit électronique **Ce** à tester. Cette manoeuvre est possible car les aiguilles ne peuvent pas tomber puisque la boucle 6 vient buter contre la face supérieure 11 de la quatrième plaque de guidage 9, qui de ce fait maintient les aiguilles 1 sensiblement dans une position d'attente de fonctionnement, comme illustré sur la partie A de la figure 2.

Sachant que, par construction, les aiguilles n'ont généralement pas toutes la même longueur et que les bornes du circuit électronique à tester **Ce** ne sont pas toutes dans un même plan, de même que les bornes de sortie du connecteur de distribution **Cd,** le connecteur intercalaire **Ca** selon l'invention permet de rattraper ces différences de niveau. Les parties B et C de la figure 2 représentent deux possibilités pour un tel rattrapage.

La partie B de la figure 2 représente le cas où une borne de sortie du connecteur de distribution **Cd** est à un niveau verticalement inférieur à celui dans la partie A, la borne du circuit électronique à tester **Ce** étant au même niveau que dans la configuration selon la partie A de cette figure 2.. Dans ce cas, la boucle 6 est comprimée par rapport à sa configuration selon la partie A de la figure 2 et elle est presque complètement comprise dans la percée oblongue 5.

La partie C de la figure représente le cas où une borne de sortie du connecteur de distribution **Cd** est au même niveau que celui illustré sur la partie B, tandis que la borne du circuit électronique **Ce** à tester est à un niveau verticalement supérieur à celui représenté sur les parties A et B de la figure 2.

Dans ce cas, la boucle 6 est plus comprimée que dans sa configuration selon la partie A de la figure 1, et elle n'est même plus au contact de la face 11 de la quatrième plaque de guidage 9 puisque sa compression s'effectue vers le haut. Elle peut même émerger de la face 51 de la troisième plaque de guidage 4, comme illustré sur cette partie C de la figure 2.

Les trois parties A, B et C de la figure 2 représentent trois déformations différentes d'une boucle 6 dans une percée oblongue 5 correspondant à trois distances différentes séparant les extrémités 7, 8 d'une aiguille.

Le fait que la percée oblongue 5 ait une largeur qui n'est que très légèrement supérieure à l'épaisseur de l'aiguille empêche une rotation de l'aiguille autour de son axe longitudinal. De ce fait, le connecteur peut comporter une pluralités d'aiguilles 1 avec leur boucle 6 situées à des distances les unes des autres inférieures à la hauteur de la boucle, sans craindre qu'une boucle puisse venir au contact d'une autre.

Il est aussi précisé que, dans un mode de réalisation préférentiel, la troisième plaque de guidage 9 et la deuxième plaque de guidage 12 qui sont traversées par une même partie 121 des aiguilles, peuvent être réalisées d'une seule pièce. Dans le cas de la figure, les percées 31 et 32 ne formeraient qu'une seule percée.

Enfin, il est précisé que les quatre plaques 2, 4, 9, 12 peuvent être réalisées en un matériau électriquement isolant comme de la céramique. Mais il est tout aussi possible qu'au moins l'une d'elles, sinon toutes, soit réalisée en un matériau électriquement conducteur et que les percées qui y sont réalisées soient alors chemisées d'une couche de matériau électriquement isolant, comme de la céramique ou analogue.

Bien entendu, la longueur des aiguilles 1 est déterminée par rapport à l'épaisseur des quatre plaques de guidage positionnées comme décrit ci-dessus, de façon que, quelles que soient les différences de niveau à rattraper entre les bornes du connecteur de distribution **Cd** et les bornes d'un circuit électronique à tester **Ce,** les extrémités 7, 8 des aiguilles émergent toujours respectivement de la face supérieure de la première plaque de guidage 2 et de la face inférieure de la deuxième plaque de guidage 12, pour venir respectivement au contact des bornes de sorties du connecteur **Cd** et du circuit à tester **Ce.**

## Revendications

1. Connecteur électrique intercalaire du type "à aiguilles" **(Ca)** pour relier les bornes d'un connecteur de distribution **(Cd)** avec les bornes d'un circuit électronique à tester **(Ce),** comportant :
• une pluralité d'aiguilles de connexion électrique (1), chaque aiguille définissant un axe général (3),
• une première plaque de guidage (2), ladite première plaque de guidage comportant des premières percées (30) parallèles entre elles et en nombre au moins égal au nombre d'aiguilles (1), la section des dites premières percées (30) étant sensiblement égale à la section transversale des dites aiguilles de façon que lesdites aiguilles puissent y coulisser sans subir de déplacements latéraux notables,
• une deuxième plaque de guidage (12), ladite deuxième plaque de guidage comportant des deuxièmes percées (31) parallèles entre elles et en nombre au moins égal au dit nombre d'aiguilles (1), la section des dites deuxièmes percées (31) étant sensiblement égale à la section transversale des dites aiguilles de façon que lesdites aiguilles puissent y coulisser sans subir de déplacements latéraux notables,
• un empilage (50) de deux troisième (4) et quatrième (9) plaques de guidage, ledit empilage étant situé entre lesdites première (2) et deuxième (12) plaques de guidage,
* ladite troisième plaque de guidage (4) comportant des troisièmes percées oblongues (5) en nombre au moins égal au dit nombre d'aiguilles (1), la largeur de la section des dites troisièmes percées oblongues (5) dans un plan perpendiculaire à l'axe général (3) étant sensiblement égale à la section transversale des dites aiguilles et sa longueur (L) supérieure à la section transversale des aiguilles, de façon que lesdites aiguilles puissent y coulisser tout en étant aptes à subir des déplacements latéraux notables par déformation élastique,
* ladite quatrième plaque de guidage (9) comportant des quatrièmes percées (32) parallèles entre elles et en nombre au moins égal au dit nombre d'aiguilles, la section des dites quatrièmes percées (32) étant sensiblement égale à la section transversale des dites aiguilles de façon que lesdites aiguilles puissent y coulisser sans subir des déplacements latéraux notables, lesdites quatre plaques de guidage (2, 12, 4, 9) étant réalisées en un matériau électriquement isolant, et
• des moyens (40) pour monter les dites première, deuxième, troisième et quatrième plaques de guidage de façon que les axes des percées correspondantes (30, 31, 32) respectivement réalisées dans les première, deuxième et quatrième plaques et aptes à recevoir une même aiguille (1) soient tous sur le même axe général (3), la troisième plaque de guidage (4) étant positionnée par rapport aux trois autres de façon que l'axe général (3) soit sensiblement tangent à la partie de paroi de la troisième percée oblongue (5) correspondant à sa largeur,
**caractérisé par le fait que** la partie des aiguilles (1) passant dans les troisièmes percées oblongues (5) réalisées dans la troisième plaque de guidage (4) est préformée en boucle (6) de façon que chaque boucle soit contenue au moins en partie dans une troisième percée oblongue (5) en y étant maintenue latéralement par les deux parties de paroi en regard de ladite percée oblongue correspondant à sa longueur.

2. Connecteur intercalaire selon la revendication 1, **caractérisé par le fait que** la première plaque de guidage (2) est constituée par au moins deux plaques auxiliaires (21, 22) situées à une certaine distance l'une de l'autre et montées parallèles entre elles, chaque première percée (30) étant constituée de deux premières percées auxiliaires (30-1, 30-2) réalisées sur le même axe général (3) respectivement dans chaque première plaque auxiliaire (21, 22).

3. Connecteur intercalaire selon l'une des revendications 1 et 2, **caractérisé par le fait que** les quatre plaques de guidage (2, 4, 9, 12) sont réalisées en céramique.

4. Connecteur intercalaire selon l'une des revendications 1 et 2, **caractérisé par le fait qu'**au moins l'une des quatre plaques de guidage (2, 4, 9, 12) est réalisée en un matériau électriquement conducteur et que les percées (30, 5, 32, 31) réalisées dans cette dite plaque sont chemisées d'une couche de matériau électriquement isolant.

5. Connecteur intercalaire selon l'une des revendications 1 à 4, **caractérisé par le fait que** les moyens de montage (40) des dites première, deuxième, troisième et quatrième plaques de guidage sont constitués par un boîtier enfermant latéralement lesdites quatre plaques de guidage (2, 4, 9, 12).

6. Connecteur intercalaire selon l'une des revendications 1 à 5, **caractérisé par le fait que** lesdites aiguilles (1) sont réalisées en un matériau élastique choisi de façon que la déformation (6) de chaque aiguille dans la troisième percée oblongue (5) correspondante forme ressort et reste dans le cadre d'une déformation élastique sans devenir une déformation plastique.

7. Connecteur intercalaire selon l'une des revendications 1 à 6, **caractérisé par le fait que** les troisième (4) et quatrième (9) plaques de guidage sont au contact l'une de l'autre.

8. Connecteur intercalaire selon l'une des revendications 1 à 7, **caractérisé par le fait que** ledit empilage (50) est positionné par rapport à la première plaque de guidage (2) de façon que leurs faces respectives en regard (51, 52) soient situées à une certaine distance l'une de l'autre non nulle.
